# FASCICULE DE BREVET EUROPEEN

(11) **EP 0 708 341 B1**
(45) Date de publication et mention de la délivrance du brevet: **15.11.2000**
(21) Numéro de dépôt: 95440064.4
(22) Date de dépôt: 06.10.1995
(51) Int. Cl.: G01R 33/60

(54) **Procédé de réglage et d'ajustement en fréquence, notamment de ponts hyperfréquences, et dispositif mettant en oeuvre un tel procédé**
Verfahren zur Regelung und Einstellung der Frequenz, besonders von Mikrowellenbrücken, und Vorrichtung zur Durchführung dieses Verfahrens
Method for frequency regulation and adjustment, in particular of microwave bridges, and device for carrying out this method

(30) Priorité: 19.10.1994 FR 9412652
(43) Date de publication de la demande: 24.04.1996
(73) Titulaire: BRUKER SA, 67160 Wissembourg (FR)
(72) Inventeur: Ringeisen, Victor, F-67160 Riedseltz (FR); Martinache, Laurent, F-67500 Haguenau (FR)
(74) Mandataire: Nuss, Pierre

(56) Documents cités:
- EP-A- 0 570 592
- DE-A- 4 125 592
- REVIEW OF SCIENTIFIC INSTRUMENTS., vol.63, no.7, 1 Juillet 1992, NEW YORK US pages 3666 - 3669 M.J. PECHAN ET AL. 'AUTOMATIC FREQUENCY CONTROL FOR SOLID-STATE SOURCES IN ELECTRON SPIN RESONANCE'
- JOURNAL OF MAGNETIC RESONANCE., vol.102A, no.3, 1 Mai 1993, ORLANDO, MN US pages 344 - 347 Y. MORITA ET AL. 'EPR OF SUBMICROLITER AQUEOUS SAMPLES USING A MICROCOIL'
- REVIEW OF SCIENTIFIC INSTRUMENTS., vol.61, no.8, 1 Août 1990, NEW YORK US pages 2248 - 2250 P. LESNIEWSKI ET AL. 'PHASE NOISE REDUCTION OF A 19 GHZ VARACTOR-TUNED GUNN OSCILLATOR FOR ELECTRON PARAMAGNETIC RESONANCE SPECTROSCOPY'
- REVIEW OF SCIENTIFIC INSTRUMENTS., vol.63, no.10, 1 Octobre 1992, NEW YORK US pages 4251 - 4262 R.W. QUINE ET AL. 'SATURATION RECOVERY ELECTRON PARAMAGNETIC RESONANCE SPECTROMETER'

## Description

La présente invention concerne de manière générale les méthodes d'accords entre émetteur et récepteur(s), notamment dans le domaine de la spectroscopie à résonance paramagnétique électronique (RPE), et plus particulièrement les techniques et les moyens de mise au point des appareils avant les mesures des caractéristiques d'échantillons, et a pour objet un procédé de réglage et d'ajustement en fréquence d'ensemble du type émetteur/récepteur, notamment de ponts hyperfréquences en spectroscopie à résonance paramagnétique électronique et un dispositif mettant en oeuvre un tel procédé.

La spectroscopie à RPE consiste à soumettre simultanément un échantillon à étudier et à caractériser, à des champs magnétiques statique (ou permanent) créé par un électro-aimant et hyperfréquence existant dans un résonateur de mesure et à analyser le rayonnement hyperfréquence réfléchi par ledit résonateur de mesure dans certaines conditions, dites de résonance, dudit échantillon.

L'appareil de génération et d'application à un échantillon d'un tel rayonnement hyperfréquence et de détection et d'analyse du rayonnement réfléchi par ledit résonateur est généralement appelé pont hyperfréquence.

Ce dernier se compose essentiellement, d'une part, d'une source hyperfréquence dont le rayonnement peut être couplé à un résonateur de mesure, disposé dans un champ magnétique permanent (entrefer d'un aimant) dans lequel peut être monté un échantillon à analyser, d'autre part, de dispositifs d'atténuation et de déphasage dudit rayonnement et, enfin, de moyens de détection du rayonnement réfléchi et d'analyse et/ou de visualisation de ce dernier.

En outre, ledit pont hyperfréquence comprend également un module, appelé circulateur, appliquant le rayonnement incident au résonateur ou à l'ensemble échantillon/résonateur et recueillant le rayonnement réfléchi par ces derniers pour l'amener auxdits moyens de détection.

En vue de l'utilisation d'un tel spectromètre, et au moment de la mise en place de l'échantillon dans le résonateur, il est notamment nécessaire d'ajuster ou de régler la source hyperfréquence du pont hyperfréquence considéré à la fréquence de résonance du résonateur, à laquelle ce dernier absorbe totalement le rayonnement incident (ce phénomène de résonance est également appelé "dip").

Afin de localiser cette fréquence d'absorption, qui varie suivant le type de résonateur et d'échantillon, et d'effectuer cet ajustage, il faut pouvoir balayer rapidement une plage de fréquence de quelques dizaines de MHz au moins au moyen de la source hyperfréquence.

Lorsque la source hyperfréquence est d'un type pouvant être accordé électroniquement sur une plage de fréquence suffisante, par exemple du type connu sous la désignation "klystron reflex", cette opération de balayage et d'ajustage peut être effectuée sans difficulté particulière.

Toutefois, il n'est pas possible de procéder ainsi pour les sources hyperfréquences dont la commande d'accord en fréquence ne balaie qu'une plage restreinte.

Or, certaines de ces sources à bande étroite présentent des qualités de fiabilité et de pureté spectrale élevées, telles que notamment les oscillateurs à diode Gunn, entraînant leur mise en oeuvre de plus en plus fréquente dans les ponts hyperfréquence.

En vue de tenter de pallier cet inconvénient, dû à l'utilisation de sources hyperfréquences à bande étroite, il a été proposé un dispositif basé sur la modulation d'un oscillateur radiofréquence (voir notamment le document DE-A-4125592).

Bien qu'il soit possible de régler un pont hyperfréquence au moyen de ce dispositif connu, la largeur de balayage obtenue n'est pas très importante et il n'est pas possible, lors de l'ajustage ou du réglage de la fréquence de la source hyperfréquence, de savoir si l'ajustement doit être effectué a priori vers des valeurs croissantes ou décroissantes de la fréquence.

Ce dernier inconvénient rend l'opération de réglage très délicate et très fastidieuse dans le cas de certaines expériences de spectroscopie.

La présente invention a pour but de pallier les inconvénients précités et de permettre un réglage rapide, dirigé et contrôlé de la fréquence, en réalisant un balayage d'une largeur très supérieure à celles pouvant être atteintes par les dispositifs connus précités, ce tout en mettant en oeuvre une structure simple et facile à manipuler.

A cet effet, la présente invention a pour objet un procédé de réglage et d'ajustement en fréquence d'ensembles du type émetteur/récepteur, notamment de ponts hyperfréquence comprenant essentiellement une source hyperfréquence principale dont le rayonnement peut être couplé à un résonateur disposé dans un champ magnétique permanent et destiné à recevoir un échantillon, caractérisé en ce qu'il consiste à soumettre le résonateur au rayonnement délivré par une source hyperfréquence secondaire balayant une large bande de fréquences comprenant notamment la fréquence de rayonnement délivré par la source hyperfréquence principale, ledit rayonnement de la source hyperfréquence secondaire étant éventuellement mélangé, avant application au résonateur, au rayonnement, fortement atténué, de la source hyperfréquence principale, à détecter le rayonnement réfléchi par ledit résonateur et éventuellement le rayonnement composite précité, à repérer les positions relatives, dans le spectre fréquentiel, d'une part, de la fréquence de la source principale, sous la forme d'un marqueur ou d'un battement et, d'autre part, de la ou des fréquence(s) de résonance dudit résonateur, sous la forme d'un pic d'absorption par fréquence de résonance, à faire varier la fréquence du rayonnement délivré par la source hyperfréquence principale en contrôlant, en temps réel, l'effet de cette variation sur les positions relatives des fréquences précitées et, enfin, à soumettre, à des fins de mesure, au moins un ensemble échantillon/résonateur au rayonnement délivré, de manière non atténuée, par la source hyperfréquence principale, ce après réglage de la fréquence sur la ou par rapport aux fréquence(s) de résonance dudit résonateur.

Elle a également pour objet un dispositif pour le réglage en fréquence d'appareils de génération de rayonnement hyperfréquence et de détection et d'analyse du rayonnement absorbé ou réfléchi résultant, adapté à la mise en oeuvre du procédé décrit ci-dessus et comprenant d'une part, une source hyperfréquence secondaire présentant une large bande de fréquences de rayonnement, d'autre part, des moyens de substitution substituant, durant l'opération de réglage, au rayonnement délivré par ladite source hyperfréquence principale du pont hyperfréquence, soit le rayonnement généré par la source secondaire, soit un rayonnement composite formé par le mélange des rayonnements issus des sources secondaire et principale, cette dernière source étant fortement atténuée, et, enfin, des moyens de détection, d'analyse et/ou de visualisation du rayonnement réfléchi par le résonateur et, le cas échéant, du rayonnement couplé audit résonateur, les moyens de détection, d'analyse et/ou de visualisation indiquant la ou les fréquence(s) de résonance (Fr) du résonateur et la fréquence du rayonnement délivré par la source hyperfréquence principale de telle sorte qu'on peut repérer, en temps réel, les positions relatives de la fréquence (F) de la source principale (1) et de la (ou des) fréquence(s) de résonance du résonateur (3).

L'invention sera mieux comprise grâce à la description ci-après, qui se rapporte à des modes de réalisation préférés, donnés à titre d'exemples non limitatifs, et expliqués avec référence aux dessins schématiques annexés, dans lesquels:
la figure 1 représente de manière schématique un pont hyperfréquence muni d'un dispositif selon l'invention, et,
la figure 2 représente, à titre d'exemple, le signal visualisant le rayonnement réfléchi en début de procédé de réglage et d'ajustement, selon une variante de réalisation de l'invention,

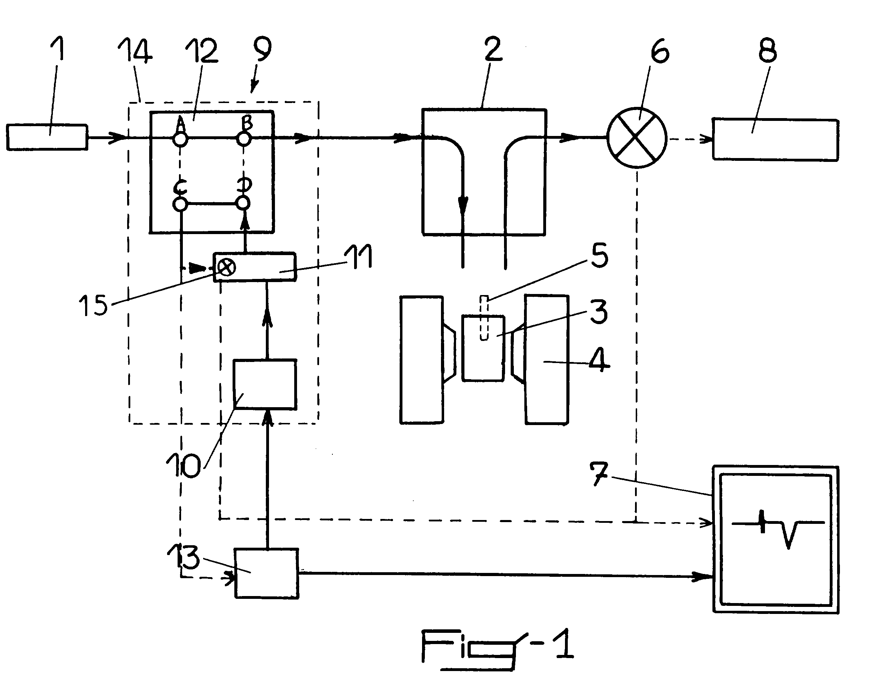

Comme le montre la figure 1 des dessins annexés, un pont hyperfréquence est, de manière générale, principalement constitué par une source hyperfréquence 1 puissante, de bonne qualité spectrale et à bande d'accord en fréquence étroite, que nous désignerons par source hyperfréquence principale dans la présente, par un module 2, dit circulateur, qui transmet le rayonnement hyperfréquence à un résonateur 3 disposé dans l'entrefer d'un aimant 4 et dans lequel peut être monté un échantillon 5 à analyser, par des moyens de détection 6 recevant le rayonnement réfléchi transmis par le circulateur 2 et par des moyens de visualisation 7 et d'analyse 8 du rayonnement incident et/ou réfléchi, pouvant être mis en oeuvre séparément ou simultanément.

Conformément à l'invention, le procédé de réglage et d'ajustement en fréquence consiste, notamment pour un pont hyperfréquence tel que décrit ci-dessus, à soumettre le résonateur 3 au rayonnement délivré par une source hyperfréquence secondaire 10 balayant une large bande de fréquences comprenant notamment la fréquence F de rayonnement délivré par la source hyperfréquence principale 1, ledit rayonnement de la source hyperfréquence secondaire 10 étant éventuellement mélangé, avant application au résonateur 3, au rayonnement, fortement atténué, de la source hyperfréquence principale 1, à détecter le rayonnement réfléchi par ledit résonateur 3 et éventuellement le rayonnement composite précité, à repérer les positions relatives, dans le spectre fréquentiel, de la fréquence F sous la forme d'un marqueur ou d'un battement B, et de la ou des fréquence(s) de résonance Fr dudit résonateur 3, sous la forme d'un pic ou "dip" d'absorption par fréquence de résonance, à faire varier la fréquence F du rayonnement délivré par la source hyperfréquence principale 1 en contrôlant, en temps réel, l'effet de cette variation sur les positions relatives des fréquences F et Fr précitées et, enfin, à soumettre, à des fins de mesure, au moins un ensemble échantillon 5/résonateur 3 au rayonnement délivré, de manière non atténuée, par la source hyperfréquence principale 1, ce après réglage de la fréquence F sur la ou par rapport aux fréquence(s) de résonance Fr dudit résonateur 3.

Selon une première caractéristique de l'invention, la source secondaire 10 est également asservie en fréquence à la source principale 1 pendant la phase de réglage de telle manière que la fréquence F de ladite source principale 1 soit toujours située au milieu de la bande de fréquences balayée par la source secondaire 10.

De manière préférentielle, et en vue de faciliter l'opération d'ajustement des fréquences F et Fr, le procédé peut avantageusement consister à asservir les moyens de visualisation 7, du rayonnement réfléchi et/ou incident au niveau du ou des résonateur(s) 3, à la source principale 1, de telle manière que la fréquence F du rayonnement de la source principale 1 occupe toujours une position particulière prédéterminée, préférentiellement la position centrale, du spectre fréquentiel visualisé.

Ainsi le réglage de la fréquence F de la source principale 1 se résume en un simple réglage visuel des positions des "dip" des résonateurs 3 ou en un simple centrage du "dip" ou pic d'absorption du résonateur 3 au niveau de l'écran des moyens de visualisation 7, affichant le signal représentant la puissance ou l'amplitude du rayonnement réfléchi par ledit résonateur 3 en fonction de la fréquence, déterminée par le rayonnement incident.

Le procédé conforme à l'invention pourra également être utilisé pour faire coïncider la fréquence F de la source principale 1 avec les fréquences Fr d'un résonateur 3, donc pour ajuster le couplage des modes de résonance du résonateur 3 de telle manière qu'ils soient sensiblement identiques pour les différentes résonances.

Les positions relatives des fréquences F et Fr peuvent être influencées et modifiées en agissant soit sur la source principale 1, soit sur le ou les résonateur(s) 3 (ce qui peut-être relativement délicat à réaliser), ou encore sur les deux.

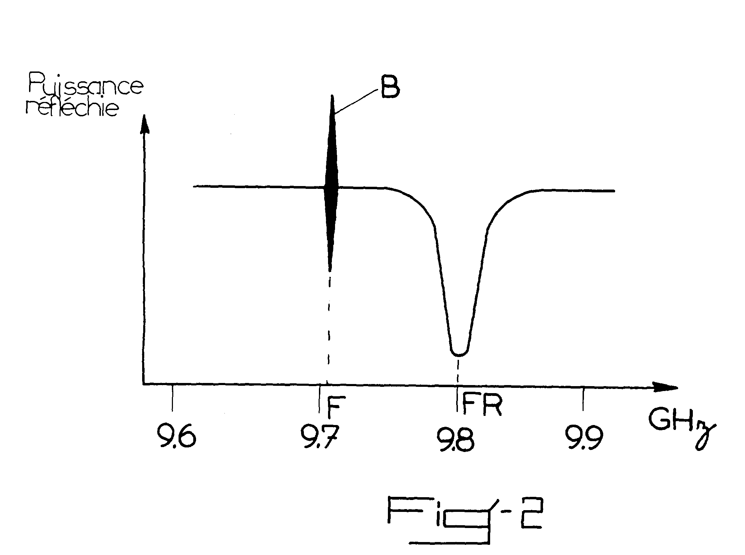

Comme le montrent les figures 1 et 2 des dessins annexés, et conformément à une caractéristique de l'invention pouvant être mise en oeuvre en variante ou en plus des dispositions précitées, il peut être prévu d'appliquer au résonateur 3 un rayonnement incident composite constitué par la superposition, d'une part, du rayonnement délivré, en étant sensiblement atténué, par la source hyperfréquence principale 1 du pont hyperfréquence et, d'autre part, du rayonnement délivré par la source hyperfréquence secondaire 10, et à repérer, en vue du réglage, dans le(s) rayonnement(s) réfléchi et/ou incident visualisé(s), un battement B formant marqueur et caractérisant la fréquence F de la source hyperfréquence principale 1 au niveau de moyens de visualisation 7, ledit battement B résultant d'un phénomène de mélange dû à la combinaison des rayonnements issus des sources hyperfréquence principales 1 et secondaire 10, lorsque les fréquences de ces deux sources sont très voisines, et pouvant être relevé au niveau des moyens de détection 6 du rayonnement réfléchi ou au niveau du moyen mélangeur 15 du rayonnement incident.

Dans ce dernier cas, le signal correspondant au rayonnement incident composite est superposé au signal correspondant au rayonnement réfléchi, au niveau des moyens de visualisation 7, avec concordance des spectres fréquentiels.

Ainsi, le rayonnement de la source hyperfréquence principale 1, fortement atténué et dont la fréquence est fixée, est donc mélangé au rayonnement, non atténué, délivré par la source hyperfréquence secondaire 1(), commandée de manière à délivrer un rayonnement dont la fréquence variable parcourt périodiquement la totalité ou une partie au moins de la plage de fréquences possibles pour cette source 1() et comprenant notamment les fréquences F et Fr, les moyens de visualisation 7 du rayonnement réfléchi et, le cas échéant, incident, fonctionnant en accord avec ledit balayage périodique.

La figure 2 montre, à titre d'exemple, un signal représentant la puissance P du rayonnement réfléchi par un résonateur 3 présentant une fréquence de résonance Fr de 9,8 GHz et soumis au rayonnement composé résultant de la superposition ou du mélange, d'une part, d'un rayonnement de fréquence F = 9,7 GHz fourni, en étant atténué, par la source hyperfréquence principale 1 et, d'autre part, d'un rayonnement à fréquence variable fourni par un oscillateur commandé pour réaliser un balayage continu de fréquence entre 9,6 et 9,9 GHz.

La fréquence de résonance Fr du résonateur 3 est visualisée par un pic négatif (dirigé vers le bas), montrant l'absorption du rayonnement incident par le résonateur 3 pour cette fréquence, et la fréquence F de la source hyperfréquence principale 1 est repérée par un marqueur ou battement B, provoqué par un phénomène de mélange et détecté au niveau des moyens de détection 6 (diode de modulation fonctionnant comme mélangeur) du rayonnement réfléchi suite à l'application du rayonnement composé précité ou au niveau du moyen mélangeur 15 (diode), lorsque les rayonnements superposés constituant ledit rayonnement composé ont des fréquences très voisines.

Il suffit alors de faire varier la fréquence F de la source hyperfréquence principale 1 jusqu'à faire coïncider ledit battement B avec le pic ou le creux négatif ("dip"), pour que ladite fréquence F soit ajustée à la fréquence de résonance Fr du résonateur 3.

La source secondaire 10, ainsi qu'un circuit coupleur 11, comprenant le cas échéant un moyen mélangeur 15, pourront être regroupés dans un boîtier spécifique et être montés sur un pont hyperfréquence, de manière amovible, durant la phase de réglage.

Il peut également être prévu, au moyen d'un module de sélection 12 relié par l'une de ses entrées à la sortie de la source hyperfréquence principale 1, de faire passer le pont hyperfréquence, d'une manière réversible, d'une première configuration, adaptée au réglage, dans laquelle le rayonnement délivré par la source hyperfréquence principale 1 est utilisé pour asservir les moyens de visualisation 7 et/ou la source hyperfréquence secondaire 10 et est, éventuellement, amené à un circuit coupleur 11 pour être superposé, après une forte atténuation, au rayonnement issu de la source hyperfréquence secondaire 10, le rayonnement de ladite source secondaire 10 ou, le cas échéant, le rayonnement résultant composé précité étant couplé au résonateur 3 et le rayonnement réfléchi par ce dernier étant visualisé, à une seconde configuration, adaptée à la mesure et à l'analyse des caractéristiques d'un échantillon 5, dans laquelle le rayonnement délivré par la source hyperfréquence principale 1 et ayant une fréquence F identique à la fréquence de résonance Fr du résonateur 3, est appliqué, seul et sans atténuation, à l'ensemble échantillon 5/résonateur 3, le rayonnement réfléchi étant analysé en vue de déterminer différentes caractéristiques de l'échantillon 5.

Une telle disposition permet un passage rapide du mode mesure au mode réglage, et réciproquement, ce qui représente un gain de temps important en cas de réglages répétés (changements de résonateur, d'échantillons, etc.) au cours d'expériences successives.

L'invention a également pour objet, comme le montre la figure 1 des dessins annexés, un dispositif pour le réglage en fréquence des ponts hyperfréquence, mettant en oeuvre le procédé décrit ci-dessus et comprenant, d'une part, une source hyperfréquence secondaire 10 présentant une large bande de fréquences de rayonnement, d'autre part, des moyens 11, 12 pour substituer, durant l'opération de réglage, au rayonnement délivré par ladite source hyperfréquence principale 1 du pont hyperfréquence, soit le rayonnement généré par la source secondaire 10, soit un rayonnement composite formé par le mélange des rayonnements issus des sources hyperfréquences secondaire 10 et principale 1, la source principale 1 étant sensiblement atténuée, et, enfin, des moyens 6, 7, 15 de détection, d'analyse et/ou de visualisation du rayonnement réfléchi par le résonateur 3 et, le cas échéant, du rayonnement couplé audit résonateur 3, permettant de repérer les positions relatives de la fréquence F de la source principale 1 et de la fréquence de résonance (au moins une) du résonateur 3.

Selon une caractéristique de l'invention, la source secondaire 10 pourra avantageusement être asservie en fréquence à la source principale 1 pendant la phase de réglage de telle manière que la fréquence F de ladite source principale 1 soit toujours située au milieu de la bande de fréquences balayée par la source secondaire 10, les moyens de visualisation mis en oeuvre le cas échéant pouvant également être asservis à la source principale 1.

La source hyperfréquence secondaire 10 pourra consister en un oscillateur large bande, associé à des moyens de commande 13 permettant d'effectuer périodiquement un balayage de la totalité ou d'une partie de la plage de fréquences de rayonnement possibles, pouvant être délivrées par ledit oscillateur, lesdits moyens de commande 13 pouvant également contrôler les moyens de visualisation 7 permettant de repérer visuellement les positions relatives dans le spectre fréquentiel, de la fréquence F de la source hyperfréquence principale I et de la fréquence de résonance Fr du résonateur 3 au moins présent.

La source hyperfréquence secondaire 10, qui n'est mise en oeuvre que durant la phase de réglage du pont hyperfréquence, n'aura pas à présenter les mêmes performances de pureté spectrale, de stabilité et de puissance que la source hyperfréquence principale 1 destinée à la mesure et à l'analyse, et pourra donc être d'une qualité et d'un prix moindres.

Les moyens de commande 13 pourront consister en un générateur de rampe permettront, par conséquent, d'obtenir un balayage en fréquence uniforme et cyclique par la source hyperfréquence secondaire 10.

Conformément à un mode de réalisation de l'invention, représentée à la figure 1 des dessins annexés, les moyens de substitution sont essentiellement constitués, par un circuit coupleur 11 destiné à appliquer au résonateur 3 le rayonnement composite ou le rayonnement issu de la source secondaire 10 et comprenant, le cas échéant, un moyen mélangeur 15 permettant de mélanger ledit rayonnement composite et, éventuellement, par un module de sélection 12 du rayonnement appliqué au résonateur 3 ou à l'ensemble échantillon 5/résonateur 3.

Pour le cas où un module de sélection 12 est prévu, ce dernier pourra avantageusement se présenter sous la forme d'un relais de transfert, qui est commutable, de manière réversible, d'un premier état, adapté au réglage du pont hyperfréquence et dans lequel le résonateur 3 est soumis à un rayonnement constitué par le rayonnement de la source secondaire 10 ou par la superposition des rayonnements délivrés par les sources hyperfréquences principale I et secondaire 10, en un second état, adapté à la mesure des caractéristiques de l'échantillon 5 et dans lequel l'ensemble échantillon 5/résonateur 3 est soumis au rayonnement délivré, de manière non atténuée, par la source hyperfréquence principale 1, le coupleur 11 et la source hyperfréquence secondaire 10 étant alors isolés du pont hyperfréquence.

La figure 1 montre schématiquement les configurations du relais de transfert 12 en mode réglage (traits interrompus entre les plots A et C/B et D) et en mode mesure/analyse (traits pleins entre les plots A et B/C et D).

Comme déjà mentionnés ci-dessus, le dispositif de réglage selon l'invention peut être mis en oeuvre de manière particulièrement avantageuse lorsque la source hyperfréquence principale 1 est à bande étroite, notamment lorsqu'elle se présente sous la forme d'un oscillateur à diode Gunn montée dans une cavité résonante.

Ledit dispositif de réglage est préférentiellement réalisé de telle manière que la source hyperfréquence secondaire 10 et les moyens de substitution 11, 12 (lorsqu'ils sont prévus) sont montés dans un boîtier indépendant 14, pouvant être monté en série dans un pont hyperfréquence, entre la source hyperfréquence 1 de celui-ci et le module circurlateur 2.

Grâce à l'invention, il est donc possible, en mode réglage, de générer et de visualiser une bande fréquentielle de largeur importante, qui n'est limitée que par les possibilités maximales des oscillateurs accordables existants, ce tout en conservant les avantages d'une source hyperfréquence principale à bande étroite, pour la mesure, le passage d'un mode à l'autre étant réalisé par simple commutation unique.

En outre, le dispositif mis en oeuvre est de structure simple et peu coûteuse, facile à utiliser et à installer dans les ponts hyperfréquences existants et peu encombrant.

Bien entendu, l'invention n'est pas limitée au mode de réalisation décrit et représenté aux dessins annexés. Des modifications restent possibles, notamment du point de vue de la constitution des divers éléments, ou par substitution d'équivalents techniques, sans sortir pour autant du domaine de protection de l'invention, qui est défini par les revendications.

## Revendications

1. Procédé de réglage et d'ajustement en fréquence d'ensembles du type émetteur/récepteur, notamment de ponts hyperfréquence comprenant essentiellement une source hyperfréquence principale dont le rayonnement peut être couplé à un résonateur disposé dans un champ magnétique permanent et destiné à recevoir un échantillon, caractérisé en ce qu'il consiste à soumettre le résonateur (3) au rayonnement délivré par une source hyperfréquence secondaire (10) balayant une large bande de fréquences comprenant notamment la fréquence (F) de rayonnement délivré par la source hyperfréquence principale (1), ledit rayonnement de la source hyperfréquence secondaire (10) étant éventuellement mélangé, avant application au résonateur (3), au rayonnement, fortement atténué, de la source hyperfréquence principale (1), à détecter le rayonnement réfléchi par ledit résonateur (3) et éventuellement le rayonnement composite précité, à repérer les positions relatives, dans le spectre fréquentiel, de la fréquence (F), sous la forme d'un marqueur ou battement, et de la ou des fréquence(s) de résonance (Fr) dudit résonateur (3), sous la forme d'un pic d'absorption par fréquence de résonance, à faire varier la fréquence (F) du rayonnement délivré par la source hyperfréquence principale (1) en contrôlant, en temps réel, l'effet de cette variation sur les positions relatives des fréquences (F et Fr) précitées et, enfin, à soumettre, à des fins de mesure, au moins un ensemble échantillon (5)/résonateur (3) au rayonnement délivré, de manière non atténuée, par la source hyperfréquence principale (1), ce après réglage de la fréquence (F) sur la ou par rapport aux fréquence(s) de résonance (Fr) dudit résonateur (3).

2. Procédé selon la revendication 1, caractérisé en ce que la source secondaire (10) est asservie en fréquence à la source principale (1) pendant la phase de réglage de telle manière que la fréquence (F) de ladite source principale (1) soit toujours située au milieu de la bande de fréquences balayée par la source secondaire (10).

3. Procédé selon l'une quelconque des revendications 1 et 2, caractérisé en ce qu'il consiste à asservir les moyens de visualisation (7), du rayonnement réfléchi et/ou incident au niveau du résonateur (3), à la source principale (1), de telle manière que la fréquence (F) du rayonnement de la source principale (1) occupe toujours une position particulière prédéterminée, préférentiellement la position centrale, du spectre fréquentiel visualisé.

4. Procédé selon l'une quelconque des revendications 1 à 3, caractérisé en ce qu'il consiste à appliquer au résonateur (3) un rayonnement incident composite constitué par la superposition, d'une part, du rayonnement délivré, en étant sensiblement atténué, par la source hyperfréquence principale (1) du pont hyperfréquence et, d'autre part, du rayonnement délivré par la source hyperfréquence secondaire (10), et à repérer, en vue du réglage, dans le(s) rayonnement(s) réfléchi et/ou incident visualisé(s), un battement (B) formant marqueur et caractérisant la fréquence (F) de la source hyperfréquence principale (1) au niveau des moyens de visualisation (7), ledit battement (B) résultant d'un phénomène de mélange dû à la combinaison des rayonnements issus des sources hyperfréquence principales (1) et secondaire (10), lorsque les fréquences de ces deux sources sont très voisines, et pouvant être relevé au niveau des moyens de détection (6) du rayonnement réfléchi ou au niveau du moyen mélangeur (15) du rayonnement incident.

5. Procédé selon l'une quelconque des revendications 1 à 4, caractérisé en ce qu'il consiste à commander la source hyperfréquence secondaire (10) en vue de délivrer un rayonnement dont la fréquence variable parcourt périodiquement la totalité ou une partie au moins de la plage de fréquences de rayonnement possibles, pouvant être délivrées par ladite source (10), les moyens de visualisation (7) du rayonnement réfléchi et, le cas échéant, incident fonctionnant en accord avec ledit balayage périodique.

6. Procédé selon l'une quelconque des revendications 1 à 5, caractérisé en ce qu'il consiste, au moyen d'un module de sélection (12) relié par l'une de ses entrées à la sortie de la source hyperfréquence principale (1), à faire passer le pont hyperfréquence, d'une manière réversible, d'une première configuration, adaptée au réglage, dans laquelle le rayonnement délivré par la source hyperfréquence principale (1) est utilisé pour asservir les moyens de visualisation (7) et/ou la source hyperfréquence secondaire (10) et est, éventuellement, amené à un circuit coupleur (11) pour être superposé, après une forte atténuation, au rayonnement issu de la source hyperfréquence secondaire (10), le rayonnement de ladite source secondaire (10) ou, le cas échéant, le rayonnement résultant composé précité étant couplé au résonateur (3) et le rayonnement réfléchi par ce dernier étant visualisé, à une seconde configuration, adaptée à la mesure et à l'analyse des caractéristiques d'un échantillon (5), dans laquelle le rayonnement délivré par la source hyperfréquence principale (1) et ayant une fréquence (F) identique à la fréquence de résonance (Fr) du résonateur (3), est appliqué, seul et sans atténuation, à l'ensemble échantillon (5)/résonateur (3), le rayonnement réfléchi étant analysé en vue de déterminer différentes caractéristiques de l'échantillon (5).

7. Dispositif pour le réglage en fréquence d'appareils de génération de rayonnement hyperfréquence et de détection et d'analyse du rayonnement absorbé ou réfléchi résultant, notamment du type pont hyperfréquence, adapté à la mise en oeuvre du procédé selon l'une quelconque des revendications 1 à 6, caractérisé en ce qu'il comprend d'une part, une source hyperfréquence secondaire (10) présentant une large bande de fréquences de rayonnement, d'autre part, des moyens (11, 12) de substitution substituant, durant l'opération de réglage, au rayonnement délivré par ladite source hyperfréquence principale (1) du pont hyperfréquence, soit le rayonnement généré par la source secondaire (10), soit un rayonnement composite formé par le mélange des rayonnements issus des sources hyperfréquences secondaire (10) et principale (1), cette dernière étant sensiblement atténuée, et, enfin, des moyens (6, 7, 15) de détection, d'analyse et/ou de visualisation du rayonnement réfléchi par le résonateur (3) et, le cas échéant, du rayonnement couplé audit résonateur (3), les moyens de détection, d'analyse et/ou de visualisation indiquant la ou les fréquence(s) de résonance (Fr) du résonateur et la fréquence du rayonnement délivré par la source hyperfréquence principale de telle sorte qu'on peut repérer, en temps réel, les positions relatives de la fréquence (F) de la source principale (1) et de la (ou des) fréquence(s) de résonance du résonateur (3).

8. Dispositif selon la revendication 7, caractérisé en ce que la source secondaire (10) est asservie en fréquence à la source principale (1) pendant la phase de réglage de telle manière que la fréquence (F) de ladite source principale (1) soit toujours située au milieu de la bande de fréquences balayée par la source secondaire (10), les moyens de visualisation (7) mis en oeuvre éventuellement pouvant également être asservis à ladite source principale (1).

9. Dispositif selon l'une quelconque des revendications 7 et 8, caractérisé en ce que la source hyperfréquence secondaire (10) consiste en un oscillateur large bande, associé à des moyens de commande (13) permettant d'effectuer périodiquement un balayage de la totalité ou d'une partie de la plage de fréquences de rayonnement possibles, pouvant être délivrées par ledit oscillateur, lesdits moyens de commande (13) pouvant également contrôler les moyens de visualisation (7) permettant de repérer visuellement les positions relatives dans le spectre fréquentiel, de la fréquence (F) de la source hyperfréquence principale (1) et de la fréquence de résonance (Fr) du résonateur (3) au moins présent.

10. Dispositif selon l'une quelconque des revendications 7 à 9, caractérisé en ce que les moyens de substitution sont essentiellement constitués par un circuit coupleur (11) destiné à appliquer au résonateur (3) le rayonnement composite ou le rayonnement issu de la source secondaire (10) et comprenant, le cas échéant, un moyen mélangeur (15) permettant de mélanger ledit rayonnement composite et, éventuellement, par un module de sélection (12) du rayonnement appliqué au résonateur (3) ou à l'ensemble échantillon (5)/résonateur (3).

11. Dispositif selon la revendication 10, caractérisé en ce que le module de sélection (12) se présente sous la forme d'un relais de transfert, qui est commutable, de manière réversible, d'un premier état, adapté au réglage du pont hyperfréquence et dans lequel le résonateur (3) est soumis à un rayonnement constitué par le rayonnement de la source secondaire (10) ou par la superposition des rayonnements délivrés par les sources hyperfréquences principale (1) et secondaire (10), en un second état, adapté à la mesure des caractéristiques de l'échantillon (5) et dans lequel l'ensemble échantillon (5)/résonateur (3) est soumis au rayonnement délivré, de manière non atténuée, par la source hyperfréquence principale (1), le coupleur (11) et la source hyperfréquence secondaire (10) étant alors isolés du pont hyperfréquence.

12. Dispositif selon l'une quelconque des revendications 7 à 11, caractérisé en ce qu'il est adapté à la mise en oeuvre du procédé lorsque la source hyperfréquence principale (1) se présente sous la forme d'un oscillateur à diode Gunn montée dans une cavité résonante.

13. Dispositif selon l'une quelconque des revendications 7 à 12, caractérisé en ce que la source hyperfréquence secondaire (10) et les moyens de substitution (11, 12) sont montés dans un boîtier indépendant (14), pouvant être monté en série dans un pont hyperfréquence.

## Patentansprüche

1. Verfahren zur Regelung und Einstellung der Frequenz von Anordnungen des Typs Sender/Empfänger, insbesondere von Mikrowellenbrücken, die im wesentlichen eine Haupt-Mikrowellenquelle aufweisen, deren Strahlung an einen Resonator gekoppelt werden kann, der in einem permanenten magnetischen Feld angeordnet und dazu bestimmt ist, eine Probe aufzunehmen, dadurch gekennzeichnet, dass es darin besteht, den Resonator (3) der Strahlung auszusetzen, die von einer sekundären Mikrowellenquelle (10) geliefert wird, die ein großes Frequenzband durchfährt, das insbesondere die Frequenz (F) der von der Haupt-Mikrowellenquelle (1) gelieferten Strahlung enthält, wobei die Strahlung der sekundären Mikrowellenquelle (10) gegebenenfalls vor dem Zuführen zu dem Resonator (3) mit der stark abgeschwächten Strahlung der Haupt-Mikrowellenquelle (1) gemischt wird, um die vom Resonator (3) reflektierte Strahlung und gegebenenfalls die oben genannte zusammengesetzte Strahlung zu detektieren, im Frequenzspektrum die jeweiligen Positionen der Frequenz (F) in Form einer Markierung oder Überlagerung und der Resonanzfrequenz oder der Resonanzfrequenzen (Fr) des Resonators (3) in Form eines Absorptionspeaks pro Resonanzfrequenz zu markieren, die Frequenz (F) der von der Haupt-Mikrowellenquelle (1) gelieferten Strahlung variieren zu lassen, wobei in Echtzeit die Wirkung dieser Variierung auf die relativen Positionen der oben genannten Frequenzen (F und Fr) kontrolliert wird und schließlich zum Zwecke der Messung wenigstens eine Anordnung Probe(5)/Resonator (3) der von der Haupt-Mikrowellenquelle (1) gelieferten, nicht abgeschwächten Strahlung auszusetzen, dies nach Regelung der Frequenz (F) auf die oder bezüglich der Resonanzfrequenz(en) (Fr) des Resonators (3).

2. Verfahren nach Anspruch 1, dadurch gekennzeichnet, dass während der Regelungsphase die Frequenz der sekundären Quelle (10) derart auf die Hauptquelle (1) geregelt wird, dass die Frequenz (F) der Hauptquelle (1) immer in der Mitte des von der sekundären Quelle (10) bestrichenen Frequenzbandes liegt.

3. Verfahren nach einem der Ansprüche 1 und 2, dadurch gekennzeichnet, dass es darin besteht, die Visualisierungsmittel (7) für die reflektierte und/oder einfallende Strahlung beim Resonator (3) auf die Hauptquelle (1) derart zu regeln, dass die Frequenz (F) der Strahlung der Hauptquelle (1) immer eine vorbestimmte, besondere Stellung, vorzugsweise die zentrale Stellung, des visualisierten Frequenzspektrums einnimmt.

4. Verfahren nach einem der Ansprüche 1 bis 3, dadurch gekennzeichnet, dass es darin besteht, dem Resonator (3) eine zusammengesetzte, einfallende Strahlung zuzuführen, die durch das Überlagern einerseits der von der Haupt-Mikrowellenquelle (1) der Mikrowellenbrücke gelieferten Strahlung, wobei diese deutlich abgeschwächt wird, und andererseits der von der sekundären Mikrowellenquelle (10) gelieferten Strahlung gebildet wird, und, hinsichtlich der Regelung, bei der/den reflektierten und/oder visualisierten einfallenden Strahlung(en) eine Überlagerung (B) zu markieren, die eine Markierung bildet und die Frequenz (F) der Haupt-Mikrowellenquelle (1) an den Visualisierungsmitteln (7) charakterisiert, wobei die Überlagerung (B) aus einem Mischungsphänomen aufgrund der Kombination der von der Haupt-(1) und sekundären (10) Mikrowellenquelle ausgegebenen Strahlungen resultiert, wenn die Frequenzen dieser beiden Quellen sehr nahe beieinander liegen, und bei den Mitteln zum Detektieren (6) der reflektierten Strahlung oder beim Mittel zum Mischen (15) der einfallenden Strahlung aufgenommen werden kann.

5. Verfahren nach einem der Ansprüche 1 bis 4, dadurch gekennzeichnet, dass es darin besteht, die sekundäre Mikrowellenquelle (10) zu steuern, um eine Strahlung zu liefern, deren variable Frequenz die Gesamtheit oder wenigstens einen Teil des Bereichs der möglichen Frequenzen der Strahlung periodisch durchläuft, die von der Quelle (10) geliefert werden kann, wobei die Visualisierungsmittel (7) der reflektierten und gegebenenfalls einfallenden Strahlung in Abstimmung mit dem periodischen Durchfahren funktionieren.

6. Verfahren nach einem der Ansprüche 1 bis 5, dadurch gekennzeichnet, dass es darin besteht, mittels eines an einem seiner Eingänge mit dem Ausgang der Haupt-Mikrowellenquelle (1) verbundenen Auswahlmoduls (12), die Mikrowellenbrücke auf umkehrbare Art von einer ersten, zur Regelung geeigneten Konfiguration, bei der die von der Haupt-Mikrowellenquelle (1) gelieferte Strahlung verwendet wird, um die Visualisierungsmittel (7) und/oder die sekundäre Mikrowellenquelle (10) zu regeln und gegebenenfalls einem Koppelkreis (11) zugeführt wird, um nach starker Abschwächung, der von der sekundären Mikrowellenquelle (10) abgegebenen Strahlung überlagert zu werden, wobei die Strahlung der sekundären Quelle (10) oder gegebenenfalls die oben genannte, zusammengesetzte, resultierende Strahlung an den Resonator (3) gekoppelt wird und die von letzterem reflektierte Strahlung visualisiert wird, in eine zweite Konfiguration übergehen zu lassen, die geeignet ist zur Messung und Analyse der Eigenschaften einer Probe (5), bei welcher Konfiguration die Strahlung, die von der Haupt-Mikrowellenquelle (1) geliefert wird und eine zur Resonanzfrequenz (Fr) des Resonators (3) identische Frequenz (F) aufweist, allein und ohne Abschwächung auf die Anordnung Probe (5)/Resonator (3) angewandt wird, wobei die reflektierte Strahlung hinsichtlich der Bestimmung von verschiedenen Eigenschaften der Probe (5) analysiert wird.

7. Vorrichtung zur Regelung der Frequenz bei Geräten zur Erzeugung von Mikrowellenstrahlung und Detektion und Analyse der absorbierten oder reflektierten resultierenden Strahlung, insbesondere der Art Mikrowellenbrücke, das zum Einsatz des Verfahrens nach einem der Ansprüche 1 bis 6 geeignet ist, dadurch gekennzeichnet, dass sie aufweist: einerseits eine ein großes Strahlungsfrequenzband aufweisende, sekundäre Mikrowellenquelle (10), und andererseits Mittel (11, 12) zum Ersetzen, die während der Operation der Regelung entweder die von der sekundären Quelle (10) erzeugte Strahlung oder eine zusammengesetzte Strahlung, die durch die Mischung der von der sekundären (10) und Haupt-Mikrowellenquelle (1) ausgegebenen Strahlung gebildet wird, wobei letztere merklich abgeschwächt ist, durch die von der Haupt-Mikrowellenquelle (1) der Mikrowellenbrücke gelieferte Strahlung ersetzen, und schließlich Mittel (6, 7, 15) zur Detektion, Analyse und/oder Visualisierung der vom Resonator (3) reflektierten Strahlung und gegebenenfalls der an den Resonator (3) gekoppelten Strahlung, wobei die Mittel zur Detektion, Analyse und/oder Visualisierung die Resonanzfrequenz(en) (Fr) des Resonators und die Frequenz der von der Haupt-Mikrowellenquelle gelieferten Strahlung anzeigen, derart, dass man, in Echtzeit, die relativen Positionen der Frequenz (F) der Hauptquelle (1) und der Resonanzfrequenz (oder der Resonanzfrequenzen) des Resonators (3) markieren kann.

8. Vorrichtung nach Anspruch 7, dadurch gekennzeichnet, dass die sekundäre Quelle (10) hinsichtlich der Frequenz während der Regelungsphase auf die Hauptquelle (1) derart geregelt wird, dass die Frequenz (F) der Hauptquelle (1) immer in der Mitte des von der sekundären Quelle (10) durchlaufenen Frequenzbandes liegt, wobei die eingesetzten Visualisierungsmittel (7) eventuell auch auf die Hauptquelle (1) geregelt werden können.

9. Vorrichtung nach einem der Ansprüche 7 und 8, dadurch gekennzeichnet, dass die sekundäre Mikrowellenquelle (10) aus einem Breitbandoszillator besteht, der mit Steuerungsmitteln (13) verbunden ist, die die periodische Durchführung eines Durchlaufs des gesamten oder eines Teils des Bereichs der möglichen Frequenzen der Strahlung, die von dem Oszillator geliefert werden können, ermöglichen, wobei die Steuerungsmittel (13) auch die Visualisierungsmittel (7) kontrollieren können, die die visuelle Markierung der jeweiligen Positionen im Frequenzspektrum der Frequenz (F) der Haupt-Mikrowellenquelle (1) und der Resonanzfrequenz (Fr) des Resonators (3), die mindestens vorhanden ist, ermöglichen.

10. Vorrichtung nach einem der Ansprüche 7 bis 9, dadurch gekennzeichnet, dass die Mittel zum Ersetzen im wesentlichen aus einem Koppelungskreis (11) bestehen, der dazu bestimmt ist, dem Resonator (3) die zusammengesetzte Strahlung oder die von der sekundären Quelle (10) ausgegebene Strahlung zuzuführen, und gegebenenfalls ein Mittel zum Mischen (15) aufweist, das das Mischen der zusammengesetzten Strahlung ermöglicht, und gegebenenfalls aus einem Modul zur Auswahl (12) der auf den Resonator (3) oder die Anordnung Probe (5)/Resonator (3) angewandten Strahlung besteht.

11. Vorrichtung nach Anspruch 10, dadurch gekennzeichnet, dass das Auswahlmodul (12) die Form eines Transferrelais aufweist, das auf umkehrbare Art von einem ersten Zustand, der für die Regelung der Mikrowellenbrücke geeignet ist und bei dem der Resonator (3) einer Strahlung unterworfen wird, die durch die Strahlung der sekundären Quelle (10) oder durch Überlagern der von der Haupt-(1) und sekundären (10) Mikrowellenquelle gelieferten Strahlungen gebildet wird, in einen zweiten Zustand umschaltbar ist, der zur Messung der Merkmale der Probe (5) geeignet ist und bei dem die Anordnung Probe (5)/Resonator (3) der von der Haupt-Mikrowellenquelle (1) gelieferten nicht abgeschwächten Strahlung unterworfen wird, wobei der Koppler (11) und die sekundäre Mikrowellenquelle (10) dann von der Mikrowellenbrücke isoliert sind.

12. Vorrichtung nach einem der Ansprüche 7 bis 11, dadurch gekennzeichnet, dass sie zum Einsatz des Verfahrens geeignet ist, wenn die Haupt-Mikrowellenquelle (1) in Form eines Oszillators mit in einem Hohlraumresonator angebrachter Gunn-Diode vorliegt.

13. Vorrichtung nach einem der Ansprüche 7 bis 12, dadurch gekennzeichnet, dass die sekundäre Mikrowellenquelle (10) und die Mittel zum Ersetzen (11, 12) in einem unabhängigen Gehäuse (14) angebracht sind, das in Serie in einer Mikrowellenbrücke angebracht werden kann.

## Claims

1. A method of frequency regulation and adjustment of assemblies of the emitter/receiver type, in particular microwave bridges essentially comprising a main microwave source, the radiation of which can be coupled to a resonator disposed in a permanent magnetic field and intended to receive a sample, characterised in that it comprises subjecting the resonator (3) to the radiation delivered by a secondary microwave source (10) sweeping a wide band of frequencies comprising in particular the frequency (F) of radiation delivered by the main microwave source (1), said radiation of the secondary microwave source (10) being possibly mixed, prior to application to the resonator (3), with the strongly attenuated radiation of the main microwave source (1), detecting the radiation reflected by said resonator (3) and possibly said composite radiation, marking the relative positions in the frequency spectrum of the frequency (F) in the form of a marker or beat and the resonance frequency or frequencies (fr) of said resonator (3) in the form of an absorption peak per resonance frequency, varying the frequency (F) of the radiation delivered by the main microwave source (1) by controlling in real time the effect of said variation on the relative positions of said frequencies (F and Fr) and finally for measurement purposes subjecting at least one sample (5)/resonator (3) assembly to the radiation delivered in non-attenuated manner by the main microwave source (1), after regulation of the frequency (F) to the or with respect to the resonance frequency or frequencies (Fr) of said resonator (3).

2. A method according to claim 1 characterised in that the secondary source (10) is controlled in respect of frequency in dependence on the main source (1) during the regulation phase in such a way that the frequency (F) of said main source (1) is always in the middle of the band of frequencies which is swept by the secondary source (10).

3. A method according to either one of claims 1 and 2 characterised in that it comprises controlling the display means (7) for the radiation which is reflected and/or incident at the location of the resonator (3) in dependence on the main source (1) in such a way that the frequency (F) of the radiation of the main source (1) always occupies a particular predetermined position, preferably the central position, in the frequency spectrum displayed.

4. A method according to any one of claims 1 to 3 characterised in that it comprises applying to the resonator (3) a composite incident radiation formed by the superimposition on the one hand of the radiation delivered, being substantially attenuated, by the main microwave source (1) of the microwave bridge and on the other hand the radiation delivered by the secondary microwave source (10) and for regulation marking in the reflected and/or incident radiation or radiations displayed a beat (B) forming a marker and characterising the frequency (F) of the main microwave source (1) at the location of the display means (7), said beat (B) resulting from a mixing phenomenon due to the combination of the radiations from the main and secondary microwave sources (1 and 10 respectively) when the frequencies of said two sources are very close, and capable of being detected at the location of the detection means (6) of the reflected radiation or at the location of the incident radiation mixer means (15).

5. A method according to any one of claims 1 to 4 characterised in that it comprises controlling the secondary microwave source (10) for delivering a radiation whose variable frequency periodically passes through all or a part at least of the range of possible radiation frequencies which can be delivered by said source (10), the means (7) for displaying the reflected radiation and possibly the incident radiation operating in accordance with said periodic sweep.

6. A method according to any one of claims 1 to 5 characterised in that it comprises, by means of a selection module (12) connected by one of its inputs to the output of the main microwave source (1), passing the microwave bridge reversibly from a first configuration adapted to regulation in which the radiation delivered by the main microwave source (1) is used to control the display means (7) and/or the secondary microwave source (10) and is possibly taken to a coupler circuit (11) to be superposed after substantial attenuation with the radiation from the secondary microwave source (10), the radiation of said secondary source (10) or possibly said composite resulting radiation being coupled to the resonator (3) and the radiation reflected by the latter being displayed, to a second configuration which is adapted to measurement and analysis of the characteristics of a sample (5), in which the radiation delivered by the main microwave source (1) and of a frequency (F) identical to the resonance frequency (Fr) of the resonator (3) is applied alone and without attenuation to the sample (5)/resonator (3) assembly, the reflected radiation being analysed to determine the different characteristics of the sample (5).

7. A device for frequency regulation of apparatuses for generating microwave radiation and detecting and analysing the resulting reflected or absorbed radiation, in particular of a microwave bridge type, adapted to carry out the method according to any one of claims 1 to 6, characterised in that it comprises on the one hand a secondary microwave source (10) having a wide band of radiation frequencies, and on the other hand substitution means (11, 12) substituting, during the regulation operation, for the radiation delivered by said main microwave source (1) of the microwave bridge, either the radiation generated by the secondary source (10) or a composite radiation formed by the mixture of the radiations from the secondary and main microwave sources (10 and 1 respectively), the latter being substantially attenuated, and finally means (6, 7, 15) for detection, analysis and/or display of the radiation reflected by the resonator (3) and possibly the radiation coupled to said resonator (3), the detection, analysis and/or display means indicating the resonance frequency or frequencies (Fr) of the resonator and the frequency of the radiation delivered by the main microwave source in such a way that it is possible in real time to mark the relative positions of the frequency (F) of the main source (1) and the resonance frequency or frequencies of the resonator (3).

8. A device according to claim 7 characterised in that the secondary source (10) is controlled in respect of frequency in dependence on the main source (1) during the regulating phase in such a way that the frequency (F) of said main source (1) is always at the centre of the frequency band swept by the secondary source (10), wherein the display means (7) used can possibly also be controlled in dependence on said main source (1).

9. A device according to either one of claims 7 and 8 characterised in that the secondary microwave source (10) comprises a wide-band oscillator associated with control means (13) making it possible periodically to effect a sweep of the whole or a part of the range of possible radiation frequencies which can be delivered by said oscillator, wherein said control means (13) can also control the display means (7) to make it possible visually to mark the relative positions in the frequency spectrum of the frequency (F) of the main microwave source (1) and the resonance frequency (Fr) of the resonator (3) which is at least present.

10. A device according to any one of claims 7 to 9 characterised in that the substitution means are essentially formed by a coupler circuit (11) intended to apply to the resonator (3) the composite radiation or the radiation from the secondary source (10) and possibly comprising a mixer means (15) for mixing said composite radiation and possibly a selection module (12) for the radiation applied to the resonator (3) or to the sample (5)/resonator (3) assembly.

11. A device according to claim 10 characterised in that the selection module (12) is in the form of a transfer relay which is reversibly switchable from a first state adapted for regulation of the microwave bridge and in which the resonator (3) is subjected to a radiation formed by the radiation of the secondary source (10) or by the superposition of the radiations delivered by the main and secondary microwave sources (1 and 10 respectively), into a second state adapted for measurement of the characteristics of the sample (5) and in which the sample (5)/resonator (3) assembly is subjected to the radiation delivered in non-attenuated manner by the main microwave source (1), the coupler (11) and the secondary microwave source (10) then being isolated from the microwave bridge.

12. A device according to any one of claims 7 to 11 characterised in that it is adapted to carry out the process when the main microwave source (1) is in the form of an oscillator with a Gunn diode mounted in a resonant cavity.

13. A device according to any one of claims 7 to 12 characterised in that the secondary microwave source (10) and the substitution means (11, 12) are mounted in an independent casing (14) which can be mounted in series in a microwave bridge.
